# EUROPEAN PATENT SPECIFICATION

(11) **EP 0 374 036 B1**
(45) Date of publication and mention of the grant of the patent: **12.10.1994**
(21) Application number: 89403450.3
(22) Date of filing: 12.12.1989
(51) Int. Cl.: H01L 21/306

(54) **Method of fabricating a semiconductor device using U.V. assisted selective multilayer etching**
Verfahren zur Herstellung von Halbleiterbauelementen durch selektives, U.V.-unterstütztes Aetzen von Mehrschichten
Procédé pour la fabrication de dispositifs à semi-conducteur utilisant la gravure sélective assistée par de l'U.V. de multicouches

(30) Priority: 13.12.1988 JP 314409/88; 14.06.1989 JP 152884/89
(43) Date of publication of application: 20.06.1990
(73) Proprietor: FUJITSU LIMITED, Kawasaki-shi, Kanagawa 211 (JP)
(72) Inventor: Kosugi, Makoto, Kanagawa 259-11 (JP); Harada, Naoki, Fujisawa-shi Kanagawa 252 (JP)
(74) Representative: Joly, Jean-Jacques

(56) References cited:
- EP-A- 0 244 304
- APPLIED PHYSICS LETTERS. vol. 49, no. 4, July 1986, NEW YORK US pages 204-206; H. KINOSHITA ET AL: "Surface oxidation of GaAs and AlGaAs in low-energy Ar/O2 reactive ion beam"
- SOLID STATE TECHNOLOGY, vol. 28, no. 4, April 1985, WASHINGTON US pages 273 -278; P. D. BREWER ET AL: "Laser-assisted dry etching"
- APPLIED PHYSICS LETTERS, vol. 45, no. 4, August 1984, NEW YORK US pages 475 -477; P. BREWER ET AL: "Photon assisted dry etching of GaAs"
- JOURNAL OF VACUUM SCIENCE AND TECHNOLOGY: PART B. vol. 3, no. 6, November 1985, NEW YORK US pages 1625-1630; H. L. CHANG ET AL: "A low temperature process for vapor etching of indium phosphide"

## Description

### BACKGROUND OF THE INVENTION

The present invention generally relates to semiconductor devices and more particularly to a method of fabricating a semiconductor device including a step of selectively removing a layer containing indium (In) by etching while leaving a layer containing aluminium (Al) unetched.

High-speed semiconductor devices such as high electron mobility transistor (HEMT) or heterojunction bipolar transistor (HBT) are studied intensively to meet the demand of increasing the operational speed of computers or telecommunication networks. These high-speed semiconductor devices are constructed using the so-called compound semiconductor materials such as gallium arsenide (GaAs) and thus, there is a need of a fabrication technique suitable for mass-producing the semiconductor devices using these compound semiconductor materials.

In recent years, there is a tendency that the conventional compound semiconductor materials such as GaAs is replaced by materials such as indium gallium arsenide (InGaAs) so as to obtain a further increased operational speed. By using InGaAs, the carrier mobility is increased further. Further, when the material is used to form a heterojunction, the density of the two-dimensional electron gas established at the heterojunction can be increased as compared to the case in which GaAs is used for the same purpose. Furthermore, there are proposed new devices such as resonant-tunneling hot electron transistor (RHET) which utilizes the wave nature of electron by confining the electron in an extremely thin region. For this purpose, a structure comprising extremely thin alternating layers of compound semiconductors such as InGaAs and indium aluminium arsenide (InAlAs) having different band gaps has to be constructed. Therefore, a technique to produce semiconductor devices or integrated circuits using InGaAs or other compound semiconductor materials containing indium (In) with a high yield is strongly needed.

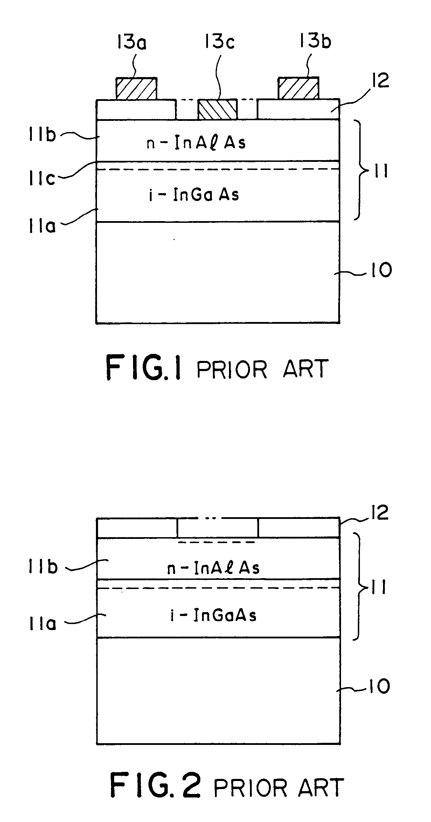

FIG.1 shows a structure of a typical HEMT device. The device comprises a substrate 10 of semi-insulating InP, an active layer 11 which in turn comprises a non-doped InGaAs layer 11a and a n-type InAlAs doped layer 11b grown thereon, and a cap layer 12 of n-type InGaAs. By constructing the structure as such, a two-dimensional electron gas is formed in the active layer 11a adjacent to a heterojunction 11c at an interface between the active layer 11a and the active layer 11b. As the active layer 11a is free from dopants, the electrons in the two-dimensional electron gas moves freely without experiencing scattering by the dopants. In order to control the two dimensional electron gas, the cap layer 12 is removed at a part corresponding to a gate structure where a gate electrode 13c is provided. Note that the threshold voltage of the HEMT is determined by the distance between the heterojunction 11c and the gate electrode 13c. Further, there are provided a source electrode 13a and a drain electrode 13b on the top of the InGaAs cap layer 12.

When forming such a structure, it is necessary to perform a process to remove part of a cap layer 12 in correspondence to the gate electrode 13c. For this purpose, a technique to etch the cap layer 12 is required. Conventionally, such an etching of the cap layer 12 has been made by using an etching solution comprising a mixture of phosphoric acid (H₃PO₄), hydrogen peroxide (H₂O₂) and water (H₂O). However, this etching solution acts not only on the InGaAs cap layer 12 but also on the InAlAs active layer 11b underneath. Therefore, there is a need to stop the process when the top surface of the InAlAs active layer 11b is exposed, so that the obtained device has an exactly controlled threshold voltage.

As will be easily understood, such a control of the etching is difficult and there is a tendency that the obtained HEMT device has a threshold voltage which is substantially scattered wafer-by-wafer. Further, as the etching is performed in the aqueous solution, the depth of etching tends to be changed in the central part and in the marginal part of the wafer. As a result, the problem of scattering of the threshold voltage arises even in the devices which are formed on a same wafer. Further, the depth of the etching tends to be changed even in a single device when the gate length of the device is large. Further, when a plurality of areas having different sizes are etched at the same time, there is a tendency that the etching proceeds more in a large sized area while the etching proceeds less in a small sized area. As a result, the upper active layer 11b tends to have various thicknesses as illustrated in FIG.2 and the threshold voltage is scattered accordingly.

On the other hand, there is a proposal to remove the InGaAs cap layer 12 by a reactive ion etching (RIE) process using an etching gas comprising a mixture of methane (CH₄) and hydrogen (H₂). This method, however, has a problem similar to the foregoing case in that the etching acts not only to the InGaAs cap layer 12 but also to the InAlAs active layer 11b. As a result, the problem of poor control of the threshold voltage occurs also in this case.

### SUMMARY OF THE INVENTION

Accordingly, it is a general object of the present invention to provide a novel and useful method of producing a semiconductor device wherein the foregoing problems are eliminated.

Another and more specific object of the present invention is to provide a method of fabricating a semiconductor device comprising a step of removing a layer containing indium by etching with selectivity relative to a layer containing aluminium.

Another object of the present invention is to provide a method of fabricating a semiconductor device wherein the semiconductor device obtained has an exactly controlled operational characteristic.

Another object of the present invention is to provide a method of fabricating a semiconductor device comprising a step of selectively removing an indium containing semiconductor layer provided on an aluminium containing semiconductor layer while leaving the aluminium containing semiconductor layer substantially unetched, said step comprising a step of exposing the first semiconductor layer containing indium to an etching gas comprising a mixture of alkyl halide and oxygen under an irradiation of ultraviolet light. According to the present invention, the first semiconductor layer is etched as a result of etching reaction taking place between the alkyl halide and elements constituting the first semiconductor layer under the ultraviolet irradiation with volatile products such as metal-organic compounds and halides produced as a result of the reaction, while once the underlying second semiconductor layer containing aluminium is exposed, the surface of the second semiconductor layer is covered with a thin film of aluminium oxide which resists against the etching. Thus, the second semiconductor layer remains substantially unetched. In other words, only the first semiconductor layer is etched selectively and the characteristic of the semiconductor device such as the threshold voltage, which is determined by the thickness of the second semiconductor layer, becomes uniform.

Another object of the present invention is to provide a method of fabricating a semiconductor device comprising a step of removing a layer containing In in an etching gas containing alkyl halide and oxygen under irradiation of ultraviolet light, wherein the etching gas is further added with hydrogen halide. According to the present invention, the variations of the etching rate or inhomogeneous etching caused by natural oxides formed before the etching and the formation of oxides during the etching are eliminated by addition of hydrogen halide which removes oxides which are formed before the etching and during the etching. Further, the intensity of ultraviolet radiation needed for the etching reaction can be reduced significantly.

Another object of the present invention is to provide a method of fabricating a semiconductor device comprising a first semiconductor layer containing indium grown on a second semiconductor layer containing aluminium, wherein a layered semiconductor body having a structure as aforementioned is at first subjected to a first atmosphere containing alkyl halide and hydrogen halide, and the first semiconductor layer is removed partially by etching performed under irradiation of a ultraviolet light. Next, the layered body is subjected to a second atmosphere containing alkyl halide, hydrogen halide and oxygen, and the first semiconductor is removed completely by etching under irradiation of the ultraviolet light while leaving the second semiconductor layer unetched. According to the present invention, the first semiconductor layer containing indium is removed homogeneously with a uniform rate by the reaction with the first atmosphere which is substantially free from oxygen, maintaining a flat exposed surface, while the etching is positively stopped at the surface of the second layer as a result of oxidization caused by oxygen which is contained in the second atmosphere in the later stage of the etching step. As a result, the surface of the second semiconductor layer acting as an active layer becomes flat and the operational characteristic of the device is controlled exactly and uniformly.

These objects are achieved by the methods as defined in claims 1, 13 and 14.

Other objects and further features of the present invention will become apparent from the following detailed description when read in conjunction with attached drawings.

### BRIEF DESCRIPTION OF THE DRAWINGS

FIG.1 is a diagram showing a structure of typical HEMT device;
FIG.2 is a diagram showing a problem associated with a prior art method for forming a HEMT structure of FIG.1;
FIG.3 is a diagram showing an apparatus used for etching in the present invention;
FIGS.4(A) through (E) are diagrams showing various steps for performing the selective etching process according to a first embodiment of the present invention;
FIG.5 is a graph showing a relation between the depth of etching and duration used for the etching;
FIGS.6(A) through (H) are diagrams showing various steps for constructing a HEMT device according to a second embodiment of the present invention;
FIG.7 is a diagram showing a step for constructing the HEMT device according to a third embodiment of the present invention;
FIGS.8(A) and (B) are diagrams showing steps of constructing the HEMT device according to a modification of the third embodiment;
FIG.9 is a graph showing a relation between the depth of etching and the flow rate of alkyl halide;
FIGS.10(A) - (I) are diagrams showing steps of constructing an RHET device according to a fourth embodiment of the present invention.

### DETAILED DESCRIPTION

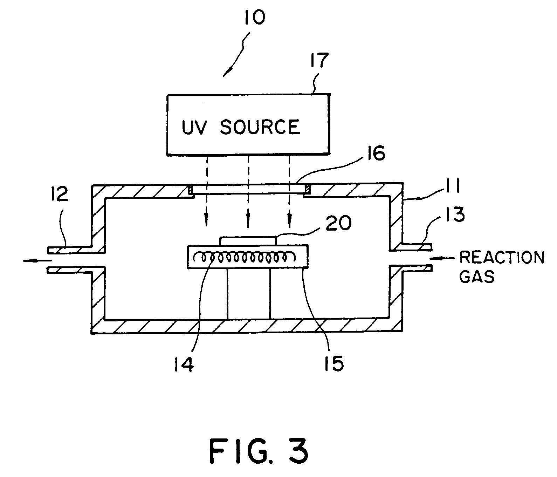

First, a description will be made on the apparatus used for etching the semiconductor layers in the present invention with reference to FIG.3.

Referring to the drawing, the etching apparatus represented by a numeral 10 comprises a reaction chamber 11 having an exhaust outlet 12 and a reaction gas inlet 13. In the reaction chamber 11, there is provided a specimen stage 15 embedded with a heater 14. Further, the reaction chamber 11 has a quartz window 16 for introducing an ultraviolet radiation emitted from an external radiation source 17 to the stage 15.

In operation, a substrate 20 which may be suitably masked by photoresist is placed on the stage 15 and the reaction chamber 11 is evacuated through the exhaust outlet 12 until the pressure in the reaction chamber 11 is reduced to about 1 Pa or less. Next, an etching gas which is pertinent to the present invention is introduced into the reaction chamber 11 through the inlet 13. During this step, the substrate 20 is heated to a predetermined temperature such as 80°C. After the introduction of the etching gas, the pressure in the reaction chamber 11 is adjusted to about 300 Pa and the ultraviolet source 17 is turned on at the same time. Responsive thereto, the radiation source 17 produces an ultraviolet radiation which has a wavelength set so as to coincide with the absorption band of etchant molecules contained in the reaction gas. As will be described later, the present invention uses alkyl halide as the etchant and the wavelength of the ultraviolet radiation is set to 184.9 nm or 253.7 nm when methyl bromide (CH₃Br), a typical alkyl halide, is used as the etchant molecule. The ultraviolet radiation thus emitted from a low pressure mercury lamp is irradiated on the substrate 20 through the quartz window 16 and responsive thereto, the alkyl halide etchant is decomposed into reactive species as a result of photochemical reaction. Chemical species thus released is combined with elements constituting the substrate 20 and forms a volatile metal-organic compounds or halides such as Ga(CH₃)ₓBr_{y}, As(CH₃)ₓBr_{y},
In(CH₃)ₓBr_{y} and the like. These species are immediately evacuated through the exhaust outlet 12 and thus, the etching reaction proceeds further.

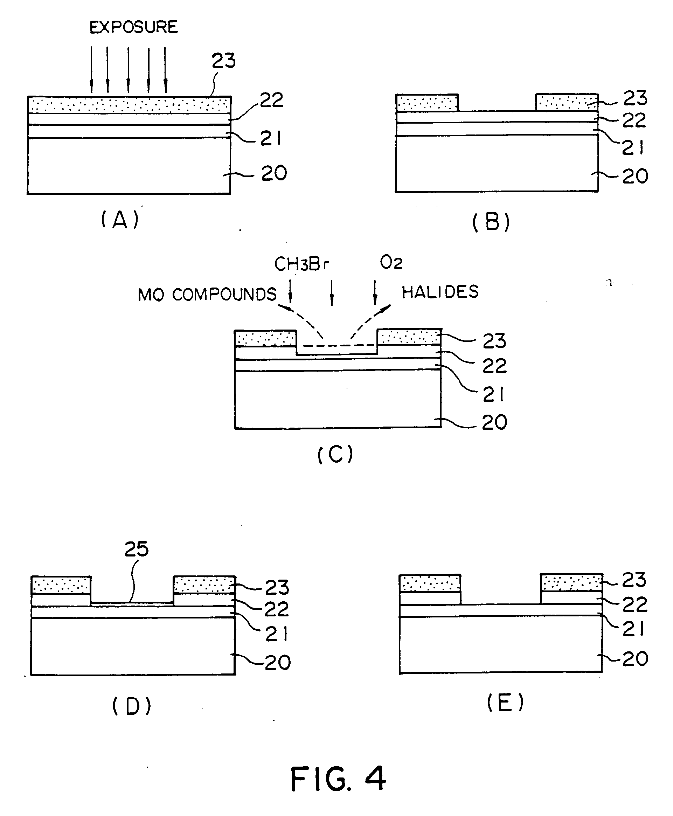

Next, the present invention will be described with reference to FIGS.4(A) through (E) showing a first embodiment. In the description hereinafter, it is assumed that the substrate 20, which may comprise InP or InGaAs, carries an InAlAs layer 21 grown thereon and an InGaAs layer 22 is further grown on the layer 21.

In a first step of FIG.4(A), a photoresist 23 is applied on a top surface of the InGaAs layer 22 and is patterned photolithographically according to a desired pattern. As a result, a structure of FIG.4(B) is obtained in which a part of the layer 22 to be removed is exposed.

Next, the structure of FIG.4(B) is incorporated into the etching apparatus of FIG.3 and is subjected to the foregoing etching procedure. It is the essential feature of the present invention that the etching is performed using a mixture of alkyl halide etchant and oxygen as the etching gas. When the mixture is introduced into the reaction chamber 11, the exposed part of the InGaAs layer 22 is removed as a result of reaction with the alkyl halide etchant as already described and a structure shown in FIG.4(C) is obtained which indicates that the etching is in progress.

Now, when the aluminium-containing layer 21 is exposed as a result of the etching, the exposed surface of the layer 21 is immediately covered with a thin layer 25 of aluminium oxide (Al₂O₃) as shown in FIG.4(D). This Al₂O₃ layer 25 is formed as a result of reaction between Al in the InAlAs layer 21 and oxygen contained in the etching gas. The layer 25 is stable against the etching reaction and thus the etching of the layer 21 is substantially prohibited once the surface of the layer 21 is exposed. This layer 25 may be removed later by aqueous solution of ammonia and a structure as shown in FIG.4(E) is obtained.

It will be understood, from the description heretofore, that the InGaAs layer 22 is selectively removed relative to the InAlAs layer 21 by simply mixing oxygen into the etching gas comprising the alkyl halide etchant without changing the process performed by the apparatus of FIG.3. Thereby, the depth of the etching is determined by the thickness of the layer 22 which can be controlled precisely at the time the layer 22 is grown. It was found that an oxygen content of about 0.3 % or more is preferable in the etching gas in order to achieve the foregoing selectivity of etching.

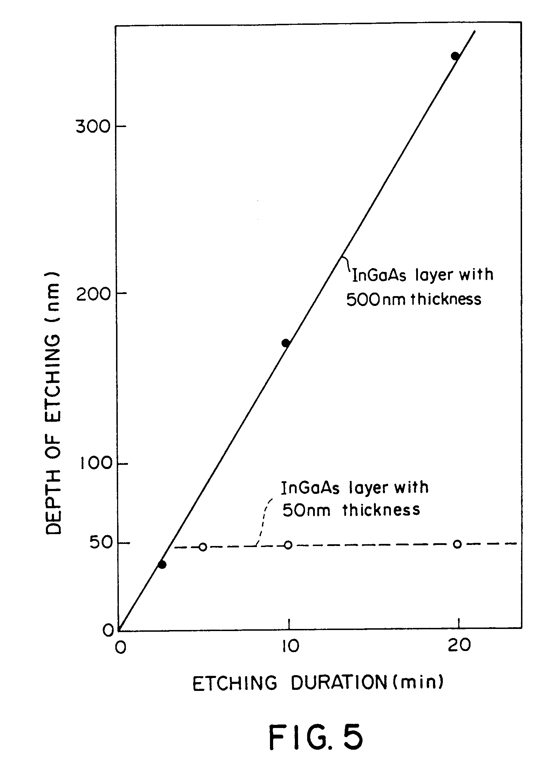

FIG.5 shows a result of etching rate measurement undertaken for the etching process shown in FIGS.4(A) through (D). Referring to FIG.5, the solid circles represent the depth of etching with time for a case in which the InGaAs layer 22 has a thickness of about 500 nm, while the open circles represent the results for a case in which the InGaAs layer 22 has a thickness of only 50 nm. As is apparently demonstrated in FIG.5, the etching of the InGaAs layer 22 is stopped in correspondence to the exposure of the interface to the underlying InAlAs layer 21 after a few minutes from the start of the etching when the InGaAs layer 22 has the thickness of 50 nm, while the etching proceeds linearly with time when the layer 22 is given the thickness of 500 nm.

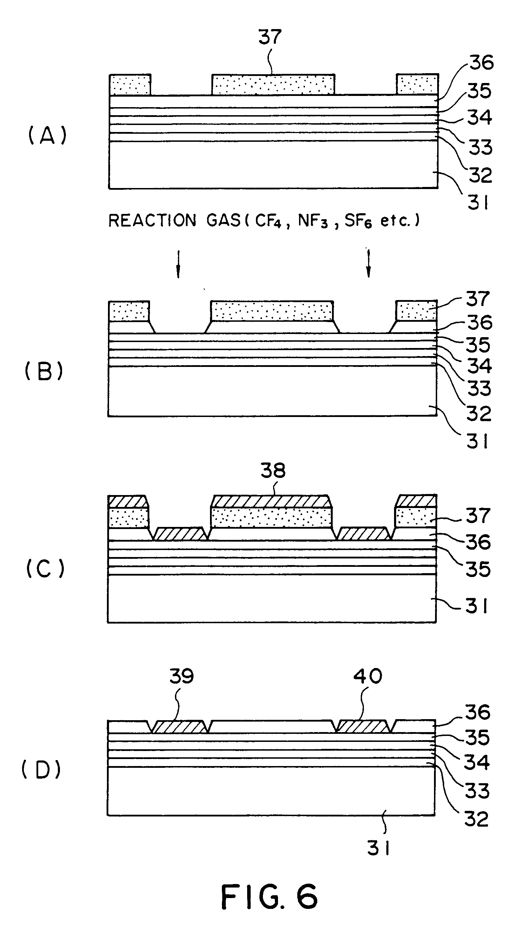

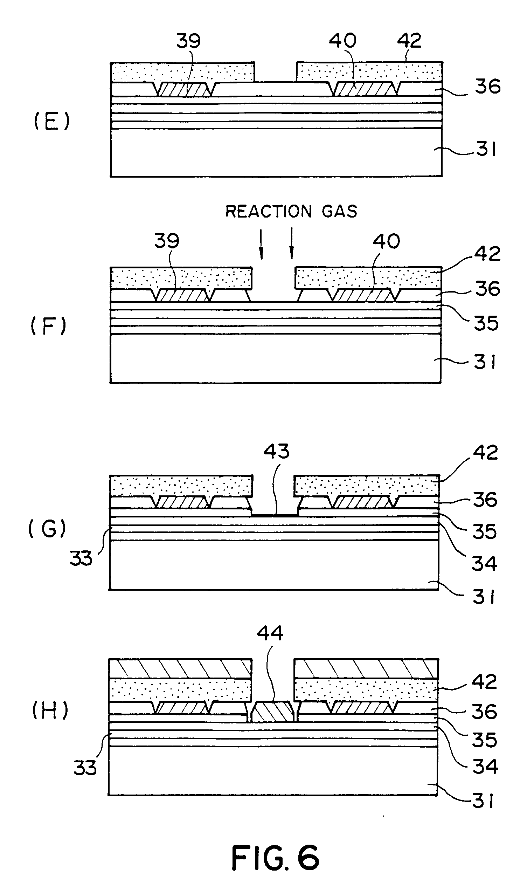

Next, a process of fabricating a HEMT device using the foregoing process will be described with reference to FIGS.6(A) through (H) as a second embodiment of the present invention.

Referring to FIG.6(A), a layered structure comprising a substrate 31 of InP, an undoped InAlAs buffer layer 32, an undoped InGaAs active layer 33, an n-type InAlAs doped layer 34, an n-type InGaAs layer 35, and an insulator layer 36 of a silicon oxynitride or SiON, is prepared by molecular beam epitaxy (MBE) or metal-organic chemical vapor deposition (MOCVD) and plasma CVD such that the layers 32 through 36 are stacked on the substrate 31 in the aforementioned order. Note that there is formed a two-dimensional electron gas in the active layer 33 of undoped InGaAs adjacent to the interface between the layer 33 and the layer 34. Further, the structure is coated with a photoresist 37 which is patterned suitably by well known photolithographic process so as to expose a part of the SiON layer 36 in correspondence to source and drain electrodes to be described.

In a step of FIG.6(B), the structure of FIG.6(A) is subjected to RIE using a reactive gas such as carbon tetrafluoride (CF₄), nitrogen trifluoride (NF₃), sulfur hexafluoride (SF₆) and the like, and the exposed part of the SiON layer 36 is removed. Next, a well known gold-germanium electrode layer 38 comprising stacked layers a gold-germanium (Au-Ge) alloy and gold (Au) is deposited as shown in FIG.6(C). Further, the electrode layer 38 is removed together with underlying photoresist 37 except for a part forming a direct contact with the n-type InGaAs layer 35 by lift-off technique. As a result, a structure shown in FIG.6(D) is obtained in which a source electrode 39 and a drain electrode 40 are provided on the layer 35 in correspondence to the exposed part of the SiON layer 36.

Next, another photoresist layer 42 is spin-coated on the structure of FIG.6(E) and is patterned photolithographically so as to expose a part of the SiON layer 36 in correspondence to the gate structure. Further, the structure of FIG.6(E) is subjected to an RIE process which is identical to the process of FIG.6(B) and the foregoing part of the SiON layer 36 corresponding to the gate structure is removed as shown in FIG.6(F).

Next, the structure of FIG.6(F) is brought into the reaction chamber 11 of the etching apparatus of FIG.3 and the procedure described with reference to FIG.4(C) is performed using the etching gas already described. Thus, the n-type InGaAs layer 35 is etched using the etching gas comprising CH₃Br and oxygen under irradiation of the ultraviolet light. When the etching has reached to the underlying n-type InAlAs layer 34, aluminium in the layer 34 is oxidized by oxygen in the etching gas and a thin Al₂O₃ layer or film 43 is formed covering the exposed surface of the layer 34 as shown in FIG.6(G). As already noted, this Al₂O₃ layer is stable against the etching and further etching proceeding into the layer 34 is prohibited.

Next, the Al₂O₃ layer 43 is removed by dipping the structure of FIG.6(G) into the aqueous solution of ammonia, and aluminium is deposited in contact with the exposed top surface of the n-type InAlAs doped layer 34 as a gate electrode 44 as shown in FIG.6(H). Further, the remaining aluminium is removed together with the photoresist 42 by lift-off and a well-known HEMT structure is completed.

According to the present embodiment, it will be noted that the distance between the gate electrode 44 and the two-dimensional electron gas at the interface between the layer 34 and the layer 35 is set equal to the thickness of the layer 35, which in turn is controlled accurately at the time of MBE or MOCVD process. Thus, the HEMT device fabricated according to the foregoing process has a uniform threshold voltage regardless of whether the device is formed in the marginal part of the wafer or in the central part of the wafer. Further, the wafer-by-wafer scattering of the threshold voltage of the device can also be eliminated by controlling the growth of the layers which is easily achieved using the existing MBE or MOCVD technique. Even when the gate length of the device is set long or changed device by device, the threshold voltage remains constant and the scattering due to the non-uniform etching does not occur.

Note that the supply of oxygen into the reaction chamber 11 may be performed in a form of various gaseous molecules containing oxygen other than oxygen molecule (O₂) such as water vapor (H₂O), nitrogen monooxide (N₂O), nitrogen dioxide (NO₂), ozone (O₃), carbon monooxide (CO), carbon dioxide (CO₂) and the like, wherein molecules which releases oxygen under irradiation of ultraviolet light is preferred. These gaseous components are introduced with an amount equivalent to 0.3 % or more of oxygen molecule.

The alkyl halide used for etching the In containing layer is not limited to CH₃Br but other materials such as methyl fluoride (CH₃F), methyl chloride (CH₃Cl), methyl iodide (CH₃I), ethyl chloride (C₂H₅Cl), ethyl bromide (C₂H₅Br), ethyl iodide (C₂H₅I), propyl iodide ((CH₃)₃I), isopropyl iodide ((CH₃)₂CHI), and the like may also be used.

Next, a third embodiment of the present invention will be described with reference to fabrication of a HEMT device.

As will be noted in the foregoing description, the essential feature of the present invention is that oxygen is added to the etching gas comprising alkyl halide so as to control the etching of the InGaAs layer such that the etching is stopped whenever the underlying InAlAs layer is exposed. However, use of the etching gas of alkyl halide admixed with oxygen causes a problem in that the etching rate tends to be changed unpredictably because of the formation of oxides on the surface of the InGaAs layer. Further, when the oxides are formed non-uniformly, there is a tendency that the surface formed by the etching becomes rough. When these problems are eliminated, a further improved uniformity is obtained for the device fabricated by the process of the present invention. The applicant has found that the variation of the etching rate during the etching of the InGaAs layer is suppressed successfully by adding hydrogen halides such as hydrogen chloride (HCl) further to the foregoing etching gas and this discovery forms the basis of the present embodiment.

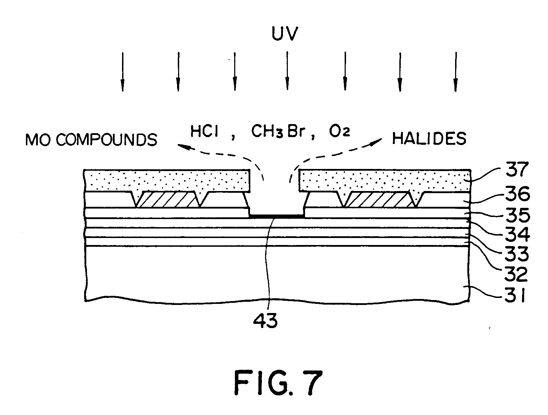

FIG.7 shows the principle of this embodiment as applied to a HEMT device similar to the one fabricated in the process shown in FIGS.6(A) through (H). In the drawing, these parts corresponding to the parts described with reference to the preceding drawings are given identical reference numerals and the description thereof will be omitted.

As is illustrated, the present embodiment employs an etching gas which is a mixture of alkyl halide such as CH₃Br, oxygen, and hydrogen halide such as HCl, wherein CH₃Br and oxygen act similarly to the first and second embodiments while HCl acts to remove oxides which are formed on the surface of the InGaAs layer 35 during the etching. Thus, the etching of the InGaAs layer 35 proceeds uniformly. Once the InAlAs layer 34 is exposed, the stable Al₂O₃ layer 43 is formed on the layer 34 similarly to the foregoing case. This Al₂O₃ layer remains stable against the action of HCl. Thus, a smooth surface is obtained at the top of the InAlAs layer 34 and the characteristic of the obtained HEMT device is stabilized. The etching is performed under a condition identical to the step of forming the structure of FIG.6(G) except the etching gas which now contains HCl.

In one modification of this embodiment, the etching step of FIG.6(G) may be performed in two stages, the first for performing the etching in an etching gas not admixed with oxygen, and the second for performing the etching in the foregoing etching gas admixed with oxygen. Thus, the first stage is performed for example by using an etching gas comprising a mixture of CH₃Br and HCl while the second stage etching is performed by using the foregoing etching gas comprising CH₃Br, oxygen and HCl. In any of the first and second stages, the temperature may be held at 80°C and the total pressure of etching gas at 300 Pa.

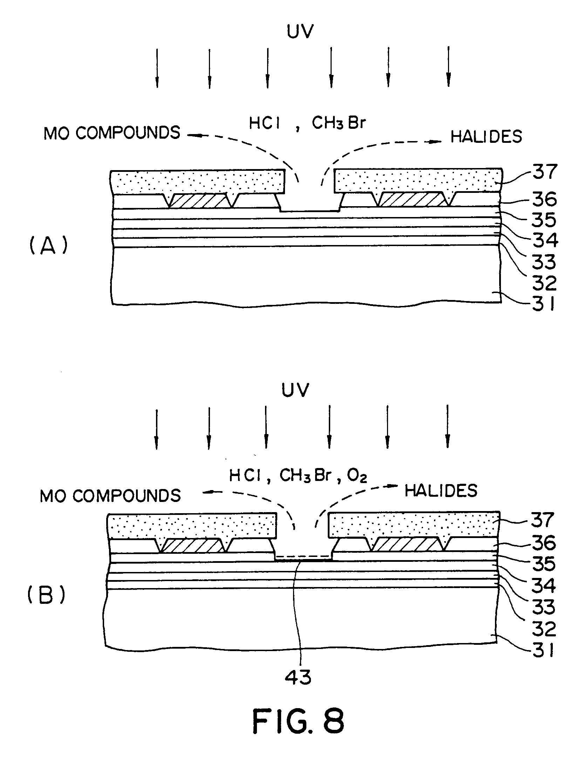

FIGS.8(A) and (B) show the first stage and second stage of etching applied to remove the InGaAs layer 35 selectively relative to the InAlAs layer 34 underneath in correspondence to the etching step of FIG.7. In the drawings, these parts described previously with reference to the preceding drawings are given identical reference numerals and the description thereof will be omitted.

In the first stage shown in FIG.8(A), the formation of oxides is minimized by supplying the etching gas which is substantially free from oxygen to the reaction chamber 11. In other words, the etching gas is a binary mixture of CH₃Br and HCl, and a residual level of oxygen is present in the gas. Such oxygen, though in the residual level, causes formation of oxides on the surface of the InGaAs layer 35 during the etching, which is undesirable from the view point of achieving a stable and uniform etching. By mixing HCl to the etching gas, the oxides are easily removed and the etching proceeds uniformly and stably with a constant etching rate while maintaining a smooth surface on the exposed InGaAs layer 35.

In the second stage etching shown in FIG.8(B) in which the surface of the InAlAs layer 34 is about to be exposed, on the other hand, oxygen is further added to the etching gas and the etching of the InGaAs layer 35 is continued while removing the oxides by HCl. When the top surface of the underlying InAlAs layer 34 is exposed, the stable Al₂O₃ layer 43 is formed and further progress of the etching is prohibited.

According to this modification, the step of etching is stabilized by not adding oxygen or oxygen-containing species to the etching gas in the initial stage of the etching while the etching is positively stopped at the surface of the Al-containing layer by introducing oxygen or the oxygen-containing species to the etching gas in the later stage of the etching.

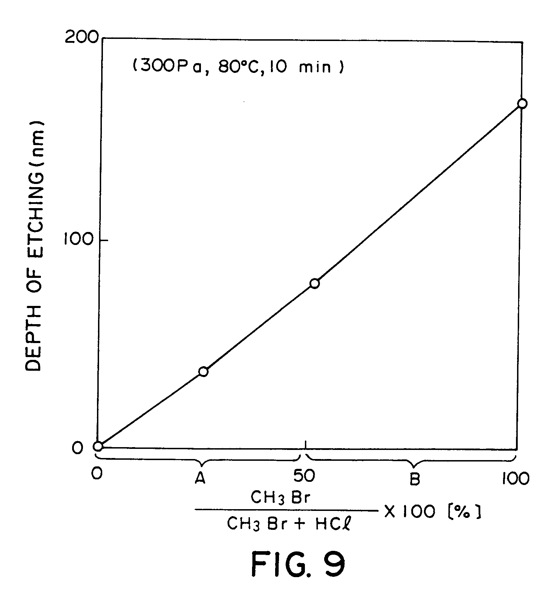

Further, associated with the change of the etching gas, it is preferred that the content of HCl is also changed. FIG.9 shows a relation between the depth of etching achieved after ten minutes of continuous etching undertaken at 80°C, 300 Pa and the flow rate of CH₃Br as normalized to a flow rate of CH₃Br and HCl. As will be noted therein, the etching rate is decreased with decreasing content of CH₃Br. Thus, addition of a large proportion of HCl, causing the relative decrease of CH₃Br, causes decrease of the etching rate as compared to the case where only a small proportion of HCl is added. When using such an etching gas containing HCl for the foregoing two-stage etching process, it is preferred to chose the content of CH₃Br to fall in a region A shown in FIG.9 in the first stage where no oxygen is admixed such that the etching rate is relatively decreased, and to chose the content to fall in a region B in the second stage etching where oxygen is admixed to the etching gas such that the etching rate is increased and the decrease of the etching rate due to the oxide formation is compensated. By setting the composition of the etching gas as such, the etching rate in the first stage etching and the second stage etching can be made substantially identical and the etching can be performed uniformly throughout the first and second stages.

Further, it was found by the applicant that the power of the ultraviolet radiation can be significantly reduced by adding hydrogen halide such as HCl to the etching gas without decreasing the etching rate.

Next, a fourth embodiment of the present invention will be described, in which the present invention is applied to construct an RHET device.

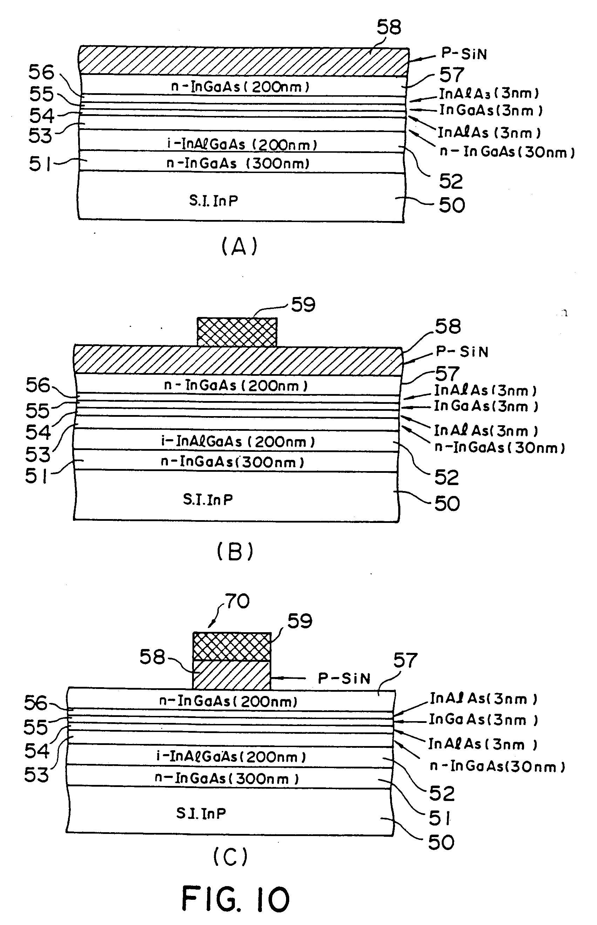

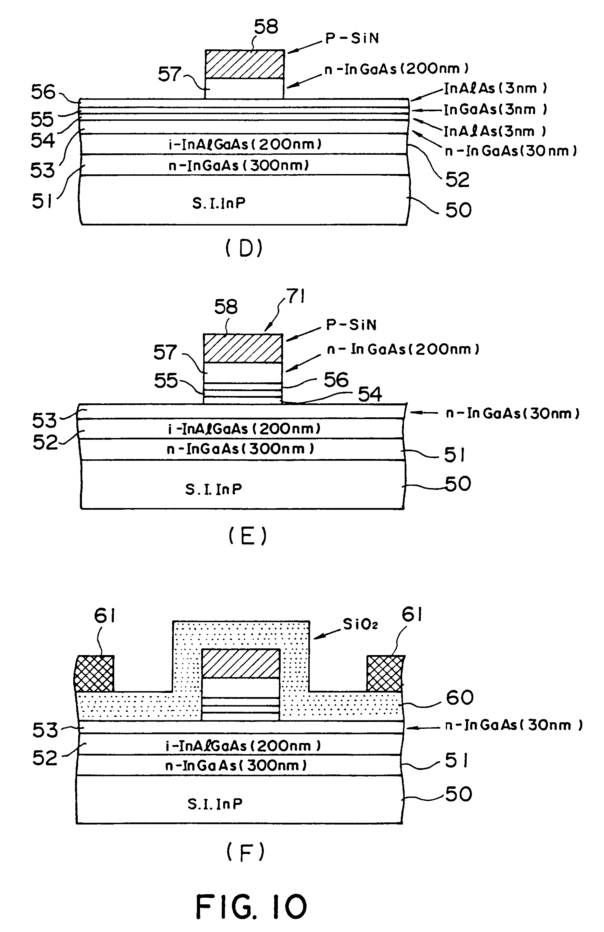

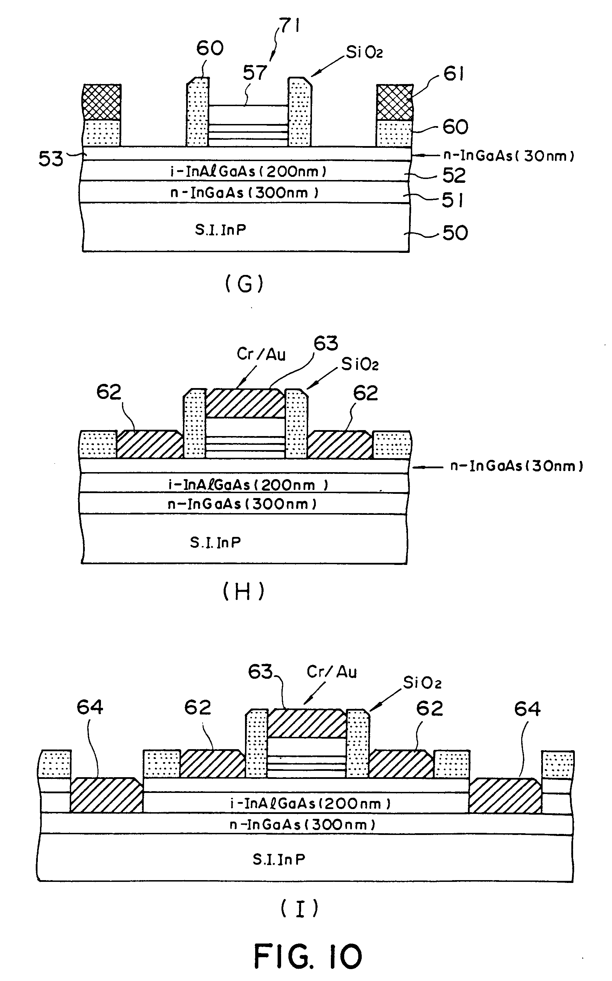

Referring to FIG.10(A), an n-type InGaAs layer 51 is grown epitaxially on a semi-insulating InP substrate 50 for a thickness of about 300 nm and an undoped indium aluminium gallium arsenide (InAlGaAs) layer 52 is further grown epitaxially on the InGaAs layer 51 for a thickness of about 200 nm. Next, an n-type InGaAs layer 53 is grown epitaxially on the layer 52 for a thickness of about 30 nm. On the layer 53, a structure comprising a pair of InAlAs layers 54, 56 sandwiching an InGaAs layer 55 is formed with a layer thickness of 3 nm for each of the layers 54, 55 and 56. Further, an n-type InGaAs layer 57 is grown epitaxially on the foregoing layered structure with a thickness of 200 nm. The growth of layers 51 through 57 on the InP substrate 50 may be performed by MBE or MOCVD. Further, a silicon nitride layer 58 shown in FIG.10(A) as P-SiN is deposited on the structure thus formed by plasma CVD technique for a thickness of 400 nm.

Next, a photoresist 59 is spin-coated on the layer 58 and is patterned such that the photoresist is remained only on a part of the layer 58 corresponding to the emitter of the RHET device as shown in FIG.10(B).

Further, the silicon nitride layer 58 is removed except for a part protected by the photoresist 59 by RIE using reactive gas such as CF₄, SF₆ or CHF₃ such that there is formed a dummy emitter structure 70 as shown in FIG.10(C).

Next, the photoresist 59 is removed and the n-type InGaAs layer 57 is removed selectively relative to the underlying InAlAs layer 56 by applying the foregoing etching procedure of the present invention while using the silicon nitride layer 58 as the mask. As a result, a structure shown in FIG.10(D) is obtained. In this etching process, the etching may be performed by using the etching gas of the mixture of CH₃Br and oxygen throughout or may be performed by changing the etching gas as described with reference to the third embodiment. As a result, the etching is stopped exactly at the top surface of the InAlAs layer 56.

Next, the layers 54 through 56 are removed except for the part covered with the remaining n-type InGaAs layer 57 by wet etching using an aqueous solution of H₃PO₄ and H₂O₂ until the top surface of the n-type InGaAs layer 53 is exposed as shown in FIG.10(E). As a result, an emitter structure 71 is formed. As the top surface of the layer 56 at the top of the layers 54 - 56 is made flat at the beginning of this etching because of the preceding etching process which utilizes the present invention, the wet etching of the layers 54 through 56, having a thickness of only 9 nm in total, proceeds uniformly and a satisfactorily flat surface is obtained for the InGaAs layer 53 acting as the base layer.

Next, the entire structure of FIG.10(E) is covered with a silicon oxide layer 60 and a photoresist 61 is deposited further thereon. Further, the photoresist 61 is patterned such that a part of the silicon oxide layer 60 is exposed as shown in FIG.10(F) and the exposed part of the silicon oxide layer 60 is removed by RIE using a reactive gas which may be a mixture of CF₄ and CHF₃ or SF₆ and CHF₃ such that a part of the base layer 53 is exposed. Furthermore, a part of the silicon oxide layer 60 covering the silicon nitride layer 58 in correspondence to the emitter structure 71 is removed and the silicon nitride layer 58 thus exposed is removed by RIE using NF₃ as the reactive gas. As a result, a structure shown in FIG.10(G) in which the silicon oxide layer 60 is left at both sides of the emitter structure 71 is obtained.

Next, an electrode layer comprising a stacking of a chromium (Cr) layer and a gold (Au) layer with a thickness of 30 nm and 300 nm respectively is deposited on the structure of FIG.10(G) and after lift-off, a structure shown in FIG.10(H) having a base electrode 62 and an emitter electrode 63 is obtained. Further, the silica layer 60 is removed in correspondence to where the collector electrode is to be provided, and deposition of a collector electrode 64 is made on the n-type InGaAs layer 51 acting as the collector layer. As a result, the RHET structure shown in FIG.10(I) is completed.

As already described, by using the process of the present invention for stopping the etching at the top surface of the InAlAs layer 56 as shown in FIG.10(D), the following etching process for removing the layers 54 - 56 to form the emitter structure 71 is controlled accurately and the exposed base layer 53 has a well controlled flat top surface. As a result, the problem such as the defective base contact or increased base resistance is avoided. Further, the homogeneity of the device characteristic throughout the wafer is guaranteed and the yield of the product is improved.

## Claims

1. A method of fabricating a semiconductor device comprising a step of removing a first material layer (22, 35, 57) containing indium provided on a second material layer (21, 34, 56) containing aluminium by etching, said method comprising a step of exposing the first material layer to an etching gas containing at least an alkyl halide etchant which reacts, responsive to an ultraviolet irradiation, with constituent elements of the first material layer and produces a volatile material as a result of the reaction, characterized in that the etching gas further contains a gaseous material containing oxygen, and the method further comprises a step of removing the first material layer selectively as to the second material layer by etching by irradiating the ultraviolet radiation on the first material layer while exposing the first material layer to the etching gas.

2. A method as claimed in claim 1 characterized in that said first material layer (22, 35, 57) comprises indium gallium arsenide and said second material layer (21, 34, 56) comprises indium aluminium arsenide.

3. A method as claimed in claim 1 characterized in that said etchant comprises methyl halide.

4. A method as claimed in claim 1 characterized in that said etchant comprises methyl bromide.

5. A method as claimed in claim 1 characterized in that said etchant is selected from a group of alkyl halides comprising methyl bromide, methyl fluoride, methyl chloride, methyl iodide, ethyl chloride, ethyl bromide, ethyl iodide, propyl iodide and isopropyl iodide.

6. A method as claimed in claim 1 characterized in that said gaseous material containing oxygen comprises a material which releases oxygen responsive to the irradiation by the ultraviolet radiation.

7. A method as claimed in claim 1 characterized in that said gaseous material is selected from a group comprising molecular oxygen, nitrogen monooxide, nitrogen dioxide, water vapor, ozone, carbon monooxide, and carbon dioxide.

8. A method as claimed in claim 1 characterized in that the method further comprises steps of exposing the first material layer (35, 57) to another etching gas comprising the etchant, and removing a part of the first material layer by irradiation of the ultraviolet radiation before the step of exposing the first material layer to the etching gas containing said gaseous material.

9. A method as claimed in claim 1 or 8 characterized in that said etching gas further contains hydrogen halide.

10. A method as claimed in claim 9 characterized in that said hydrogen halide comprises hydrogen chloride.

11. A method as claimed in claim 9 characterized in that said hydrogen halide comprises hydrogen bromide.

12. A method as claimed in claim 9 characterized in that said etching gas is changed with concentration of hydrogen halide during said step of removing the first material layer (35, 57).

13. A method of fabricating a high electron mobility transistor comprising an active layer (33) of indium gallium arsenide, a doped layer (34) of indium aluminium arsenide grown on the active layer, and a cap layer (35) of indium gallium arsenide grown on the doped layer, characterized by steps of exposing a part of the cap layer to an etching gas containing at least an alkyl halide etchant which reacts, responsive to an ultraviolet irradiation, with constituent elements of the cap layer and produces a volatile material as a result of the reaction, said etching gas further containing a gaseous material containing oxygen, removing said exposed part of the cap layer selectively as to the doped layer by irradiating the ultraviolet radiation on said cap layer while maintaining the exposure of the cap layer to the etching gas until a top surface of the doped layer is exposed, and depositing a gate electrode on the exposed top surface of the doped layer.

14. A method of fabricating a resonant-tunneling hot electron transistor having an emitter structure (71) comprising a first barrier layer (54) of indium aluminium arsenide provided on a base layer (53), a quantum well layer (55) of indium gallium arsenide provided on the first barrier layer, a second barrier layer (56) of indium aluminium arsenide provided on the quantum well layer, and a cap layer (57) of indium gallium arsenide provided on the second barrier layer, characterized by steps of exposing a part of the cap layer to an etching gas containing at least an alkyl halide etchant which reacts, responsive to an ultraviolet irradiation, with constituent elements of the cap layer and produces a volatile material as a result of the reaction, said etching gas further containing a gaseous material containing oxygen, removing said exposed part of the cap layer selectively as to the second barrier layer by irradiating the ultraviolet radiation on said cap layer while maintaining the exposure of the cap layer to the etching gas until the second barrier layer is exposed, removing an exposed part of the second barrier layer, a part of the quantum well layer and a part of the first barrier layer located under the exposed part of the second barrier layer until the base layer is exposed, and depositing a base electrode on an exposed part of the base layer.

## Patentansprüche

1. Verfahren zur Herstellung einer Halbleitereinrichtung, enthaltend einen Schritt des Entfernens einer Indium enthaltenden ersten Materialschicht (22, 35, 57), die auf einer Aluminium enthaltenden zweiten Materialschicht (21, 34, 56) vorgesehen ist, durch Ätzen, wobei das Verfahren einen Schritt eines Exponierens der ersten Materialschicht gegenüber einem Ätzgas enthält, das mindestens ein Alkylhalidätzmittel enthält, welches ansprechend auf eine ultraviolette Bestrahlung mit Bestandteilselementen der ersten Materialschicht reagiert und ein flüchtiges Material als ein Ergebnis der Reaktion erzeugt, dadurch gekennzeichnet, daß das Ätzgas weiterhin ein Sauerstoff enthaltendes gasförmiges Material enthält, und das Verfahren weiterhin enthält einen Schritt eines Entfernens der ersten Materialschicht selektiv in Bezug auf die zweite Materialschicht durch Ätzen unter Einstrahlung der ultravioletten Strahlung auf die erste Materialschicht, während die erste Materialschicht dem Ätzgas ausgesetzt wird.

2. Verfahren nach Anspruch 1, dadurch gekennzeichnet, daß die erste Materialschicht (22, 35, 57) Indium-Gallium-Arsenid enthält und die zweite Materialschicht (21, 34, 56) Indium-Aluminium-Arsenid enthält.

3. Verfahren nach Anspruch 1, dadurch gekennzeichnet, daß das Ätzmittel Methylhalid enthält.

4. Verfahren nach Anspruch 1, dadurch gekennzeichnet, daß das Ätzmittel Methylbromid enthält.

5. Verfahren nach Anspruch 1, dadurch gekennzeichnet, daß das Ätzmittel ausgewählt ist aus einer Gruppe von Alkylhaliden, enthaltend Methylbromid, Methylfluorid, Methylchlorid, Methyliodid, Ethylchlorid, Ethylbromid, Ethyliodid, Propyliodid und Isopropyliodid.

6. Verfahren nach Anspruch 1, dadurch gekennzeichnet, daß das Sauerstoff enthaltende gasförmige Material ein Material enthält, welches Sauerstoff in Ansprache auf die Bestrahlung durch die ultraviolette Strahlung freisetzt.

7. Verfahren nach Anspruch 1, dadurch gekennzeichnet, daß das gasförmige Material ausgewählt ist aus einer Gruppe enthaltend molekularen Sauerstoff, Stickstoffmonoxid, Stickstoffdioxid, Wasserdampf, Ozon, Kohlenmonoxid und Kohlendioxid.

8. Verfahren nach Anspruch 1, dadurch gekennzeichnet, daß das Verfahren enthält weitere Schritte des Exponierens der ersten Materialschicht (35, 57) gegenüber einem das Ätzmittel enthaltenden anderen Ätzgas, und des Entfernens eines Teils der ersten Materialschicht durch Einstrahlung der ultravioletten Strahlung vor dem Schritt des Exponierens der ersten Materialschicht gegenüber dem das gasförmige Material enthaltenden Ätzgas.

9. Verfahren nach Anspruch 1 oder 8, dadurch gekennzeichnet, daß das Ätzgas weiterhin Wasserstoffhalid enthält.

10. Verfahren nach Anspruch 9, dadurch gekennzeichnet, daß das Wasserstoffhalid Wasserstoffchlorid umfaßt.

11. Verfahren nach Anspruch 9, dadurch gekennzeichnet, daß das Wasserstoffhalid Wasserstoffbromid umfaßt.

12. Verfahren nach Anspruch 9, dadurch gekennzeichnet, daß das Ätzgas während des Schritts des Entfernens der ersten Materialschicht (35, 57) mit Konzentration des Wasserstoffhalids verändert wird.

13. Verfahren zur Herstellung eines Transistors mit hoher Elektronenmobilität, enthaltend eine aktive Schicht (33) aus Indium-Gallium-Arsenid, eine auf die aktive Schicht aufgewachsene dotierte Schicht (34) aus Indium-Aluminium-Arsenid, und eine auf die dotierte Schicht aufgewachsene Deckschicht (35) aus Indium-Gallium-Arsenid, gekennzeichnet durch Schritte des Exponierens eines Teils der Deckschicht gegenüber einem Ätzgas, das mindestens ein Alkylhalidätzmittel enthält, welches in Ansprache auf eine ultraviolette Bestrahlung mit Bestandteilselementen der Deckschicht reagiert und ein flüchtiges Material als ein Ergebnis der Reaktion erzeugt, wobei das Ätzgas weiterhin ein Sauerstoff enthaltenes gasförmiges Material enthält, eines Entfernens des freigelegten Teils der Deckschicht selektiv in Bezug zu der dotierten Schicht durch Einstrahlung der ultravioletten Strahlung auf die Deckschicht, während das Exponieren der Deckschicht gegenüber dem Ätzgas beibehalten wird bis eine obere Oberfläche der dotierten Schicht freigelegt ist, und des Aufbringens einer Gatterelektrode auf der freigelegten oberen Oberfläche der dotierten Schicht.

14. Verfahren zur Herstellung eines Resonanztunnelungs-Heißelektronentransistors mit einer Emitterstruktur (71) enthaltend eine erste Sperrschicht (54) aus Indium-Aluminium-Arsenid, die auf einer Basisschicht (53) vorgesehen ist, eine Quantengrabenschicht (55) aus Indium-Gallium-Arsenid, die auf der ersten Sperrschicht vorgesehen ist, eine zweite Sperrschicht (56) aus Indium-Aluminium-Arsenid, die auf der Quantengrabenschicht vorgesehen ist, und eine Deckschicht (57) aus Indium-Gallium-Arsenid, die auf der zweiten Sperrschicht vorgesehen ist, gekennzeichnet durch Schritte des Exponierens eines Teils der Deckschicht gegenüber einem Ätzgas, das mindestens ein Alkylhalidätzmittel enthält, welches ansprechend auf eine ultraviolette Bestrahlung mit Bestandteilselementen der Deckschicht reagiert und ein flüchtiges Material als ein Ergebnis der Reaktion erzeugt, wobei das Ätzgas weiterhin ein Sauerstoff enthaltendes gasförmiges Material enthält, des Entfernens des freigelegten Teils der Deckschicht selektiv in Bezug zu der zweiten Sperrschicht durch Einstrahlung der ultravioletten Strahlung auf die Deckschicht, während das Exponieren der Deckschicht gegenüber dem Ätzgas beibehalten wird, bis die zweite Sperrschicht freigelegt ist, des Entfernens eines freigelegten Teils der zweiten Sperrschicht, eines Teils der Quantengrabenschicht und eines Teils der ersten Sperrschicht, der unter dem freigelegten Teil der zweiten Sperrschicht befindlich ist, bis die Basisschicht freigelegt ist, und der Aufbringung einer Basiselektrode auf einem freigelegten Teil der Basisschicht.

## Revendications

1. Procédé de fabrication d'un dispositif à semi-conducteur comprenant une étape consistant à retirer une première couche de matériau (22, 35, 57) contenant de l'indium disposée sur une seconde couche de matériau (21, 34, 56) contenant de l'aluminium par gravure, ledit procédé comprenant une étape consistant à exposer la première couche de matériau à un gaz de gravure contenant au moins un agent de gravure constitué par un halogénure d'alkyle qui réagit, en réponse à une irradiation ultraviolette, avec les éléments constitutifs de la première couche de matériau et qui produit un matériau volatil par suite de la réaction, caractérisé en ce que le gaz de gravure contient en outre un matériau gazeux contenant de l'oxygène, et le procédé comprend en outre une étape de retrait de la première couche de matériau sélectivement par rapport à la seconde couche de matériau par gravure par irradiation du rayonnement ultraviolet sur la première couche de matériau tandis que la première couche de matériau est exposée au gaz de gravure.

2. Procédé selon la revendication 1, caractérisé en ce que ladite première couche de matériau (22, 35, 57) comprend de l'arséniure d'indium et de gallium et ladite seconde couche de matériau (21, 34, 56) comprend de l'arséniure d'indium et d'aluminium.

3. Procédé selon la revendication 1, caractérisé en ce que ledit agent de gravure comprend un halogénure de méthyle.

4. Procédé selon la revendication 1, caractérisé en ce que ledit agent de gravure comprend du bromure de méthyle.

5. Procédé selon la revendication 1, caractérisé en ce que ledit agent de gravure est choisi dans le groupe formé par les halogénures d'alkyle comprenant le bromure de méthyle, le fluorure de méthyle, le chlorure de méthyle, l'iodure de méthyle, le chlorure d'éthyle, le bromure d'éthyle, l'iodure d'éthyle, l'iodure de propyle et l'iodure d'isopropyle.

6. Procédé selon la revendication 1, caractérisé en ce que ledit matériau gazeux contenant de l'oxygène comprend un matériau qui libère de l'oxygène en réponse à l'irradiation par le rayonnement ultraviolet.

7. Procédé selon la revendication 1, caractérisé en ce que ledit matériau gazeux est choisi dans le groupe formé par l'oxygène moléculaire, le monoxyde d'azote, le dioxyde d'azote, la vapeur d'eau, l'ozone, le monoxyde de carbone et le dioxyde de carbone.

8. Procédé selon la revendication 1, caractérisé en ce que le procédé comprend en outre des étapes d'exposition de la première couche de matériau (35, 57) à un autre gaz de gravure comprenant l'agent de gravure, et de retrait d'une partie de la première couche de matériau par irradiation du rayonnement ultraviolet avant l'étape d'exposition de la première couche de matériau au gaz de gravure contenant ledit matériau gazeux.

9. Procédé selon la revendication 1 ou 8, caractérisé en ce que ledit gaz de gravure contient en outre un halogénure d'hydrogène.

10. Procédé selon la revendication 9, caractérisé en ce que ledit halogénure d'hydrogène comprend du chlorure d'hydrogène.

11. Procédé selon la revendication 9, caractérisé en ce que ledit halogénure d'hydrogène comprend du bromure d'hydrogène.

12. Procédé selon la revendication 9, caractérisé en ce que la concentration de l'halogénure d'hydrogène dans ledit gaz de gravure est modifiée pendant ladite étape de retrait de la première couche de matériau (35, 57).

13. Procédé de fabrication d'un transistor à mobilité élecronique élevée comprenant une couche active (33) d'arséniure d'indium et de gallium, une couche dopée (34) d'arséniure d'indium et d'aluminium qui a été amenée à croître sur la couche active, et une couche de couverture (35) d'arséniure d'indium et de gallium qui a été amenée à croître sur la couche dopée, caractérisé par les étapes consistant à exposer une partie de la couche de couverture à un gaz de gravure contenant au moins un agent de gravure constitué par un halogénure d'alkyle qui réagit, en réponse à un rayonnement ultraviolet, avec les éléments constitutifs de la couche de couverture et qui produit un matériau volatil par suite de la réaction, ledit gaz de gravure contenant en outre un matériau gazeux contenant de l'oxygène, à retirer ladite partie exposée de la couche de couverture sélectivement par rapport à la couche dopée, par irradiation du rayonnement ultraviolet sur ladite couche de couverture tandis que l'exposition de la couche de couverture au gaz de gravure est maintenue jusqu'à ce qu'une surface supérieure de la couche dopée soit exposée, et à déposer une électrode de grille sur la surface supérieure exposée de la couche dopée.

14. Procédé de fabrication d'un transistor à effet tunnel résonant ayant une structure d'émetteur (71) comprenant une première couche de barrière (54) d'arséniure d'indium et d'aluminium formée sur une couche de base (53), une couche de puits quantique (55) d'arséniure d'indium et de gallium formée sur la première couche de barrière, une seconde couche de barrière (56) d'arséniure d'indium et d'aluminium formée sur la couche de puits quantique, et une couche de couverture (57) d'arséniure d'indium et de gallium formée sur la seconde couche d'arrêt, caractérisé par les étapes consistant à exposer une partie de la couche de couverture à un gaz de gravure contenantau moins un agent de gravure constitué par un halogénure d'alkyle qui réagit, en réponse à un rayonnement ultraviolet, avec les éléments constitutifs de la couche de couverture et qui produit un matériau volatil par suite de la réaction, ledit gaz de gravure contenant en outre un matériau gazeux contenant de l'oxygène, à retirer ladite partie exposée de la couche de couverture sélectivement par rapport à la seconde couche de barrière par irradiation du rayonnement ultraviolet sur ladite couche de couverture tandis que l'exposition de la couche de couverture au gaz de gravure est maintenue jusqu'à ce que la seconde couche d'arrêt soit exposée, à retirer une partie exposée de la seconde couche de barrière, une partie de la couche de puits quantique et une partie de la première couche de barrière située sous la partie exposée de la seconde couche de barrière jusqu'à ce que la couche de base soit exposée, et à déposer une électrode de base sur une partie exposée de la couche de base.
